# EUROPEAN PATENT APPLICATION

(11) **EP 4 160 223 A1**
(43) Date of publication of application: **05.04.2023**
(21) Application number: 21812949.2
(22) Date of filing: 21.05.2021
(51) Int. Cl.: G01R 11/56, G01R 21/00, G01R 35/00, H02J 13/00, H02J 3/38

(54) **POWER MANAGEMENT SYSTEM, POWER CONVERSION DEVICE, AND POWER MANAGEMENT METHOD**

(30) Priority: 27.05.2020 JP 2020091886
(71) Applicant: Kyocera Corporation, Kyoto-shi Kyoto 612-8501 (JP)
(72) Inventor: HIDAKA Hiroyuki, Kyoto-shi, Kyoto 612-8501 (JP)
(74) Representative: TBK
(86) International application number: PCT/JP2021/019377
(87) International publication number: WO 2021/241442

(57) **Abstract**

A power management system includes a first receiver for receiving, at a predetermined time interval, a reference measurement value of a reference power meter, a second receiver for receiving, at an interval shorter than the predetermined time interval, a first measurement value of a first power meter provided closer to a power system side than a merging point of a power line connected to a distributed power supply and a power line connected to a load device, a third receiver for receiving, at an interval shorter than the predetermined time interval, a second measurement value of a second power meter for measuring power consumption of the load device, and a controller for executing a first calibration process related to the first power meter based on a comparison result between the reference measurement value and the first measurement value and subsequently executing a second calibration process related to the second power meter based on the first measurement value and the second measurement valu

## Description

### TECHNICAL FIELD

The present disclosure relates to a power management system, a power conversion device and a power management method.

### BACKGROUND OF INVENTION

A system for trading output power of a distributed power supply such as a solar cell apparatus or a power storage apparatus by measuring the output power of the distributed power supply is known. In such a system, measurement accuracy is ensured by measuring the output power of the distributed power supply with a power meter certified by a third party organization (hereinafter referred to as a certified meter).

A system has been proposed in which a measurement value of a measurement device for measuring power consumption of a load device provided in a facility or a measurement device for measuring output power of a distributed power supply provided in the facility is calibrated using a power meter for measuring flow power or reverse flow power of the facility (hereinafter referred to as a smart meter). Such a system attempts to ensure the measurement accuracy of the measurement device by calibration using the smart meter without using the certified meter (for example, Patent Document 1).

### CITATION LIST

### PATENT LITERATURE

Patent Document 1: WO 2011/067988 Pamphlet

### SUMMARY

A power management system according to a first aspect includes: a first receiver configured to receive, at a predetermined time interval, a reference measurement value of a reference power meter configured to measure flow power and/or reverse flow power of a facility comprising a distributed power supply and a load device; a second receiver configured to receive, at an interval shorter than the predetermined time interval, a first measurement value of a first power meter provided closer to a power system side than a merging point of a power line connected to the distributed power supply and a power line connected to the load device; a third receiver configured to receive, at an interval shorter than the predetermined time interval, a second measurement value of a second power meter configured to measure power consumption of the load device; and a controller configured to execute a first calibration process related to the first power meter, based on a comparison result between the reference measurement value and the first measurement value and subsequently execute a second calibration process related to the second power meter, based on the first measurement value and the second measurement value.

A power conversion device according to a second aspect includes: a first power interface connected to a power system; a second power interface connected to a load device, a third power interface connected to a distributed power supply; a merging point of a power line connected to the distributed power supply and a power line connected to the load device; and a converter configured to at least convert direct current power output from the distributed power supply to alternating current power.

A power management method according to a third aspect includes: receiving, at a predetermined time interval, a reference measurement value of a reference power meter configured to measure flow power and/or reverse flow power of a facility comprising a distributed power supply and a load device; receiving, at an interval shorter than the predetermined time interval, a first measurement value of a first power meter provided closer to a power system side than a merging point of a power line connected to the distributed power supply and a power line connected to the load device; receiving, at an interval shorter than the predetermined time interval, a second measurement value of a second power meter configured to measure power consumption of the load device; and executing a first calibration process related to the first power meter, based on a comparison result between the reference measurement value and the first measurement value and subsequently executing a second calibration process related to the second power meter, based on the first measurement value and the second measurement value.

### BRIEF DESCRIPTION OF THE DRAWINGS

FIG. 1 illustrates a power management system 100 according to an embodiment.
FIG. 2 illustrates a PCS 230 according to the embodiment.
FIG. 3 is a diagram illustrating a power management method according to the embodiment.
FIG. 4 is a diagram illustrating a power management method according to the embodiment.
FIG. 5 is a diagram illustrating a power management method according to the embodiment.
FIG. 6 is a diagram illustrating a power management method according to the embodiment.
FIG. 7 is a diagram illustrating a power management method according to a variation 1.
FIG. 8 illustrates the PCS 230 according to a variation 2.

### DESCRIPTION OF EMBODIMENTS

Embodiments will be described below with reference to the accompanying drawings. Note that in the following description of the drawings, the same or similar components will be denoted by the same or similar reference signs. However, the drawings are schematic.

### Embodiment

### Power Management System

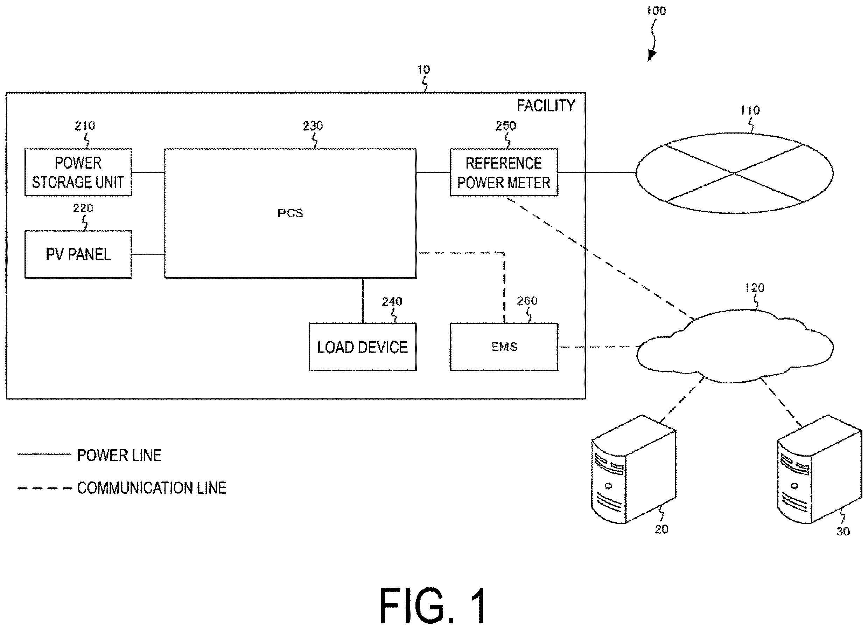

A power management system according to an embodiment will be described below. As illustrated in FIG. 1, a power management system 100 includes a facility 10, a server 20, and a server 30. The facility 10 is connected to a power system 110 with a power line. The facility 10 is connected to a network 120 with a communication line. The power line may be wired, although not particularly limited thereto. The communication line may be wireless or wired. The facility 10, the server 20, and the server 30 are connected through the network 120. The network 120 is the Internet. The network 120 may include a dedicated line such as a virtual private network (VPN). In the following description, the flow of power from the power system 110 to the facility 10 is referred to as a power flow, and the flow of power from the facility 10 to the power system 110 is referred to as a reverse power flow.

The facility 10 is a facility including distributed power supplies (a power storage unit 210 and a PV panel 220 in FIG. 1) and a load device 240. The facility 10 may be a non-commercial facility such as a house, or may be a commercial facility such as an office or a store, although not particularly limited thereto. The facility 10 may be a factory.

For example, the facility 10 includes the power storage unit 210, the PV panel 220, a power conditioning system (PCS) 230, the load device 240, a reference power meter 250, and an energy management system (EMS) 260.

The power storage unit 210 is an example of the distributed power supplies for charging power and discharging power. The power storage unit 210 may be an example of the distributed power supplies in which reverse power flow is not allowed. The power storage unit 210 may be an example of the distributed power supplies to which feed-in tariff (FIT) is not applied. However, reverse power flow may be allowed in the power storage unit 210 and the FIT may be applied to the power storage unit 210. For example, the power storage unit 210 is an example of a first distributed power supply. The power storage unit 210 may be an example of a second distributed power supply.

The PV panel 220 is an example of the distributed power supplies for generating power with use of sunlight or other light. The PV panel 220 may be an example of the distributed power supplies in which reverse power flow is allowed. The PV panel 220 may be an example of the distributed power supplies to which FIT is applied. For example, the PV panel 220 is an example of the second distributed power supply. The PV panel 220 may be an example of the first distributed power supply.

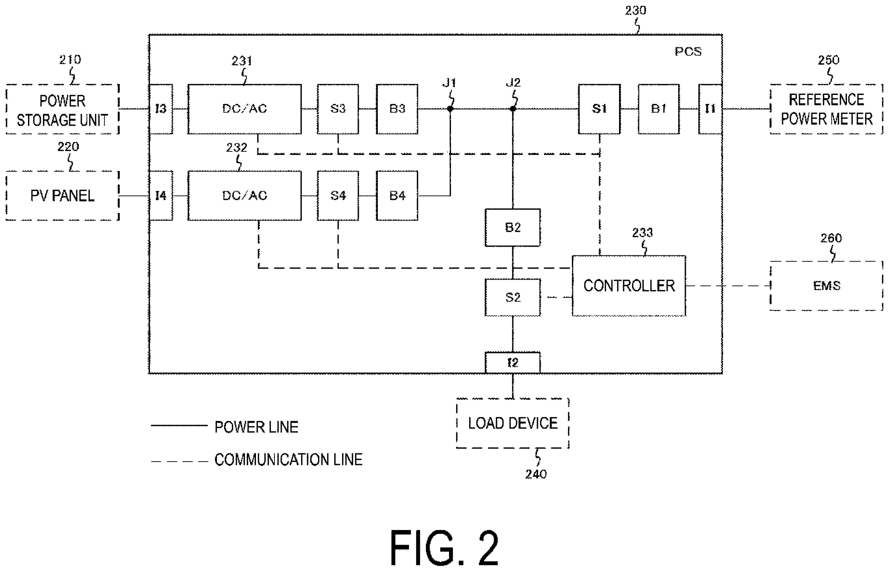

The PCS 230 is an example of a power conversion device for converting DC power output from the distributed power supplies into AC power. For example, the PCS 230 converts DC power output from the power storage unit 210 into AC power, and converts AC power into DC power to be input to the power storage unit 210. The PCS 230 converts DC power output from the PV panel 220 into AC power. The details of the PCS 230 will be described below (see FIG. 2).

The load device 240 is a device that consumes power. The load device 240 may include an air conditioning device and may include a lighting device, although not particularly limited thereto.

The reference power meter 250 measures at least one of flow power or reverse flow power of the facility 10. The reference power meter 250 is a power meter authenticated by a third party organization, and is a power meter belonging to a power company, although not particularly limited thereto. The reference power meter 250 has a function to transmit a reference measurement value of the reference power meter 250 at predetermined time intervals (for example, 30 minutes). The reference power meter 250 may be a power meter suppressed from transmitting the reference measurement value at an interval shorter than the predetermined time interval.

The EMS 260 manages the power of the facility 10. For example, the EMS 260 may manage the flow power of the facility 10, and may manage the reverse flow power of the facility 10. The EMS 260 may manage output power (discharging power) of the power storage unit 210, input power (charging power) of the power storage unit 210, and output power (generated power) of the PV panel 220. The EMS 260 may manage power consumption of the load device 240.

The EMS 260 is connected to the PCS 230 with a communication line, and may acquire the power described above from the PCS 230. Although omitted in FIG. 1, the EMS 260 is connected to various power meters (S1, S2, S3, and S4) described below with a communication line, and may acquire the power described above from the various power meters.

The server 20 is a server for managing the power system 110. The server 20 may be a server managed by a power producer, a power distributer or a retailer, or a business operator such as a resource aggregator. The server 20 may transmit a control message instructing control for the distributed power supplies in a virtual power plant (VPP). The control message may include a power flow control message (for example, a demand response (DR)) for requesting control of the flow power, may include a reverse power flow control message for requesting control of the reverse flow power, and may include a power control message for controlling an operation state of the distributed power supply.

The server 30 is a server for managing the distributed power supplies provided in the facility 10. The server 30 may be a server that is managed by an entity for providing or manufacturing the distributed power supplies, although not particularly limited thereto. For example, the server 30 may collect information such as output power of the distributed power supplies, input power of the distributed power supplies, or the like, for the purpose of maintenance or the like of the distributed power supplies. The server 30 may collect information such as the flow power of the facility 10, the reverse flow power of the facility 10, the power consumption of the load device 240, the output power of the distributed power supplies, and the input power of the distributed power supplies, for the purpose of optimization of the operation or the like of the distributed power supplies. The information of the power collected by the server 30 may be used for a purpose other than that described above.

### Power Conversion Device

The power conversion device according to the embodiment will be described below. As described above, the PCS 230 is an example of the power conversion device.

As illustrated in FIG. 2, the PCS 230 includes various interfaces (I1, 12, I3 and I4 in FIG. 2), various breakers (B1, B2, B3, and B4 in FIG. 2), various power meters (S1, S2, S3, and S4 in FIG. 2), and various merging points (J1 and J2 in FIG. 2). The PCS 230 includes a DC/AC converter 231 (simply DC/AC in FIG. 2), a DC/AC converter 232 (simply DC/AC in FIG. 2), and a controller 233.

I1 is an example of a first power interface connected to the power system 110 (reference power meter 250 in FIG. 2). I2 is an example of a second power interface connected to the load device 240. I3 and I4 are examples of third power interfaces connected to respective ones of the plurality of first distributed power supplies. In FIG. 2, I3 is an example of a power interface connected to the power storage unit 210, and I4 is an example of a power interface connected to the PV panel 220. Each of these power interfaces may be constituted by a connector. However, the embodiment is not limited thereto, and each of the power interfaces may be a power line without the connector.

B1 is provided on a power line connecting J2 and I1, and is configured to be able to switch between connection and disconnection of the power line. B 1 may be used as a limiter for limiting a current of the facility 10 to a value equal to or less than a value agreed in a contract between the facility 10 and the power company. When B1 is disconnected, the facility 10 is disconnected from the power system 110. B2 is provided on a power line connecting J2 and 12, and is configured to be able to switch between connection and disconnection of the power line. When B2 is disconnected, the load device 240 is disconnected from the power system 110. B3 is provided on a power line connecting J1 and 13, and is configured to be able to switch between connection and disconnection of the power line. When B3 is disconnected, the power storage unit 210 is disconnected from the power system 110. B4 is provided on a power line connecting J1 and I4, and is configured to be able to switch between connection and disconnection of the power line. When B4 is disconnected, the PV panel 220 is disconnected from the power system 110.

S1 is an example of the first power meter provided closer to the power system 110 side than J2. S1 measures at least one of the flow power or the reverse flow power of the facility 10. In theory, a value obtained by integrating the first measurement value of S1 at a predetermined time interval matches the reference measurement value of the reference power meter described above. S2 is provided between J2 and I2, and is an example of a second power meter for measuring the power consumption (in other words, a second measurement value) of the load device 240. S3 is provided between J1 and I3, and is an example of a third power meter (for example, a first distributed power supply power meter) for measuring at least one (in other words, a third measurement value) of the output power of the power storage unit 210 (for example, the first distributed power supply) and the input power of the power storage unit 210. S4 is provided between J1 and I4, and is an example of the third power meter (for example, the second distributed power supply power meter) for measuring the output power (in other words, the third measurement value) of the PV panel 220 (for example, the second distributed power supply). In theory, the sum of the third measurement values of S3 and S4 matches the difference between the first measurement value of S1 and the second measurement value of S2. In other words, if the influence of the measurement value of S4 can be eliminated, the sum of the third measurement values of S3 matches the difference between the first measurement value of S1 and the second measurement value of S2, and if the influence of the measurement value of S3 can be eliminated, the sum of the third measurement values of S4 matches the difference between the first measurement value of S1 and the second measurement value of S2.

In the embodiment, each of S1 to S4 need not be a power meter authenticated by a third party organization like the reference power meter 250. However, each of S1 to S4 may be a power meter authenticated by a third party organization.

J1 is a merging point of a power line connected to the power storage unit 210 and a power line connected to the PV panel 220. J2 is a merging point of a power line connected to the distributed power supplies and a power line connected to the load device 240. J2 is provided closer to the power system 110 side than J1.

The DC/AC converter 231 converts DC power output from the power storage unit 210 into AC power, and converts AC power into DC power to be input to the power storage unit 210. The DC/AC converter 231 is an example of a converter for at least converting direct current power output from a distributed power supply into alternating current power.

The DC/AC converter 232 converts DC power output from the PV panel 220 into AC power. The DC/AC converter 232 is an example of a converter for at least converting direct current power output from a distributed power supply into alternating current power.

The controller 233 includes a communication module, and has a function of communicating with the various power meters, the reference power meter 250, and the EMS 260. The communication module may be a wireless communication module compliant with standards such as IEEE 802.11a/b/g/n, ZigBee, Wi-SUN, LTE, and 5G, or may be a wired communication module compliant with standards such as IEEE 802.3.

In the embodiment, the controller 233 constitutes a first receiver for receiving the reference measurement value of the reference power meter 250 at the predetermined time interval. The controller 233 constitutes a second receiver for receiving the first measurement value of the first power meter (S 1 in FIG. 2) at an interval (for example, one minute) shorter than the predetermined time interval. The controller 233 constitutes a third receiver for receiving the second measurement value of the second power meter (S2 in FIG. 2) at an interval (for example, one minute) shorter than the predetermined time interval. The controller 233 constitutes a fourth receiver for receiving the third measurement value of the third power meter (S3 or S4 in FIG. 2) at an interval (for example, one minute) shorter than the predetermined time interval.

The controller 233 includes at least one processor and controls the PCS 230. The at least one processor may be constituted by a single integrated circuit (IC) or a plurality of circuits (such as integrated circuits and/or discrete circuits) connected so as to be capable of communicating with each other.

First, the controller 233 executes a first calibration process related to S1 based on a comparison result between the reference measurement value and the first measurement value. The first calibration process may include a process of determining whether an error in S1 (first measurement value) with respect to the reference power meter 250 (reference measurement value) falls within an acceptable range. The first calibration process may include a process of calculating a correction coefficient for correcting the first measurement value in a case where the error in S1 (first measurement value) does not fall within the acceptable range.

Here, in the case where the error in S1 (first measurement value) does not fall within the acceptable range, S 1 may be notified with a message to stop the use of S1 and replace S1, or the use of S1 may be continued while correcting the first measurement value by the correction coefficient.

Second, the controller 233 executes the first calibration process and subsequently executes a second calibration process related to S2 based on the first measurement value and the second measurement value. The second calibration process may include a process of determining whether an error in S2 (second measurement value) with respect to S1 (first measurement value) falls within an acceptable range. The second calibration process may include a process of calculating a correction coefficient for correcting the second measurement value in a case where the error in S2 (second measurement value) does not fall within the acceptable range.

Here, in the case where the error in S2 (second measurement value) does not fall within the acceptable range, S2 may be notified with a message to stop the use of S2 and replace S2, or the use of S2 may be continued while correcting the second measurement value by the correction coefficient.

The controller 233 may execute the second calibration process in a period in which a variation in at least one of the output power or the input power of the distributed power supply is equal to or less than a predetermined threshold value. For example, assuming a case in which the distributed power supply is the power storage unit 210, the second calibration process may be executed in a period in which the variation in the output power and the input power of the power storage unit 210 are equal to or less than a predetermined threshold value. In the same or a similar fashion, assuming a case in which the distributed power supply is the PV panel 220, the second calibration process may be executed in a period (for example, night) in which the variation in the output power of the PV panel 220 is equal to or less than a predetermined threshold value. The controller 233 may execute the second calibration process in a state in which B3 and/or B4 is disconnected. The period in which B3 and/or B4 is disconnected is synonymous with the period in which the variation in the output power and/or the input power of the distributed power supply is equal to or less than the predetermined threshold value.

Third, the controller 233 executes, after the second calibration process is executed, a third calibration process related to S3 based on the first measurement value, the second measurement value, and the third measurement value. In the same or a similar fashion, the controller 233 executes, after the second calibration process is executed, a third calibration process related to S4 based on the first measurement value, the second measurement value, and the third measurement value. The third calibration process may include a process of determining whether an error in S3 (third measurement value) with respect to the difference between the first measurement value and the second measurement value falls within an acceptable range. The third calibration process may include a process of calculating a correction coefficient for correcting the third calibration process in a case where the error in S3 (third measurement value) does not fall within the acceptable range. In the same or a similar fashion, the third calibration process may include a process of determining whether an error in S4 (third measurement value) with respect to the difference between the first measurement value and the second measurement value falls within an acceptable range. The third calibration process may include a process of calculating a correction coefficient for correcting the third calibration process in a case where the error in S4 (third measurement value) does not fall within the acceptable range.

Here, in the case where the error in S3 (third measurement value) does not fall within the acceptable range, S3 may be notified with a message to stop the use of S3 and replace S3, or the use of S3 may be continued while correcting the third measurement value by the correction coefficient. In the same or a similar fashion, in the case where the error in S4 (third measurement value) does not fall within the acceptable range, S4 may be notified with a message to stop the use of S4 and replace S4, or the use of S4 may be continued while correcting the third measurement value by the correction coefficient.

The controller 233 may execute the third calibration process in a period in which a variation in the power consumption of the load device 240 is equal to or less than a predetermined threshold value. The controller 233 may execute the third calibration process in a state in which B2 is disconnected. The period in which B2 is disconnected is synonymous with the period in which the variation in the power consumption of the load device 240 is equal to or less than the predetermined threshold value.

As described above, the controller 233 may execute, as the third calibration process, at least one of the calibration process related to S3 or the calibration process related to S4. In a case of executing both the calibration process related to S3 and the calibration process related to S4, the controller 233 may execute the third calibration process as illustrated below.

Specifically, the controller 233 may execute the calibration process related to S3 in the period in which the variation in the output power of the PV panel 220 is equal to or less than the predetermined threshold value. The controller 233 may execute the calibration process related to S3 in a state in which B4 is disconnected. The period in which B4 is disconnected is synonymous with the period in which the variation in the output power of the PV panel 220 is equal to or less than the predetermined threshold value. In the same or a similar fashion, the controller 233 may execute the calibration process related to S4 in a period in which a variation in the output power of the power storage unit 210 is equal to or less than the predetermined threshold value. The controller 233 may execute the calibration process related to S4 in a state in which B3 is disconnected. The period in which B3 is disconnected is synonymous with the period in which the variation in the output power of the power storage unit 210 is equal to or less than the predetermined threshold value.

### Power Management Method

A power management method according to the embodiment will be described below.

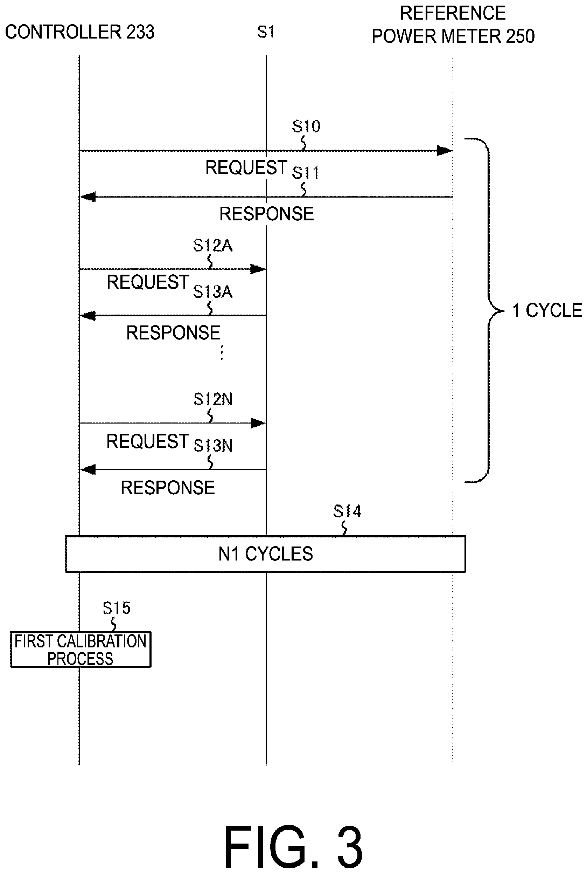

First, the first calibration process will be described with reference to FIG. 3. The first calibration process is a calibration process related to S1.

As illustrated in FIG. 3, in step S10, the controller 233 requests the reference measurement value from the reference power meter 250. In step S11, the controller 233 receives from the reference power meter 250 a response (reference measurement value) to the request. As described above, the controller 233 receives the reference measurement value at each predetermined time interval. In FIG. 3, the reference power meter 250 transmits the reference measurement value in response to the request from the controller 233, but may autonomously transmit the reference measurement value at each predetermined time interval. Although not particularly limited, a message such as GET, GET response, and INF can be used as a message used in step S10 and step S11.

In step S12A, the controller 233 requests the first measurement value from S1. In step S13A, the controller 233 receives from S1 a response (first measurement value) to the request. In FIG. 3, S1 transmits the first measurement value in response to the request from the controller 233, but may autonomously transmit the first measurement value at an interval shorter than the predetermined time interval. Although not particularly limited, a message such as GET, GET response, and INF can be used as a message used in step S12A and step S13A.

Here, the controller 233 receives the first measurement value a number of times N within the predetermined time interval. The number of times N is not particularly limited, but in a case where a reception time interval of the reference measurement value is 30 minutes and a reception time interval of the first measurement value is one minute, N may be 30.

In step S14, the controller 233 sets step S10 to step S13N as one cycle, and executes such a process for N1 cycles. The N1 cycles is the number of repetitions to ensure accuracy of the first calibration process, is not particularly limited, and may be four. Step S10 to step S13N may be counted as one cycle included in the N1 cycles.

In step S15, the controller 233 executes the first calibration process related to S1 based on the comparison result between the reference measurement value and the first measurement value. The first measurement value to be compared with the reference measurement value is an integrated value of the first measurement value received for the number of times N.

Here, the controller 233 can acquire the comparison results of N1 cycles. The first calibration process may be executed based on an average value of errors in the first measurement values, may be executed based on a minimum value of the errors in the first measurement values, or may be executed based on a maximum value of the errors in the first measurement values.

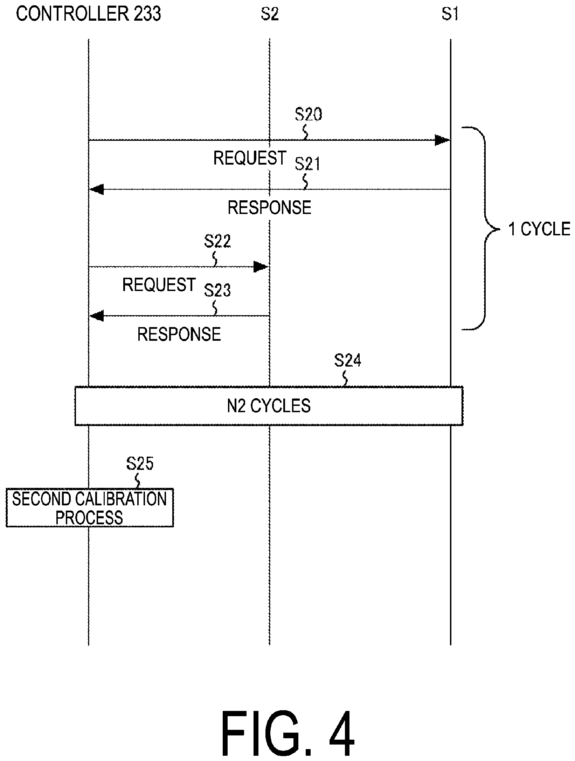

Second, the second calibration process will be described with reference to FIG. 4. The second calibration process is a calibration process related to S2. The second calibration process is executed at least after the first calibration process is executed.

As illustrated in FIG. 4, in step S20, the controller 233 requests the first measurement value from S1. In step S21, the controller 233 receives from S1 a response (first measurement value) to the request. In FIG. 4, S1 transmits the first measurement value in response to the request from the controller 233, but may autonomously transmit the first measurement value at an interval shorter than the predetermined time interval. Although not particularly limited, a message such as GET, GET response, and INF can be used as a message used in step S20 and step S21.

In step S22, the controller 233 requests the second measurement value from S2. In step S23, the controller 233 receives from S2 a response (second measurement value) to the request. In FIG. 4, S2 transmits the second measurement value in response to the request from the controller 233, but may autonomously transmit the second measurement value at an interval shorter than the predetermined time interval. Although not particularly limited, a message such as GET, GET response, and INF can be used as a message used in step S22 and step S23.

In step S24, the controller 233 sets step S20 to step S23 as one cycle, and executes such a process for N2 cycles. The N2 cycles is a repetition number for ensuring accuracy of the second calibration process, is not particularly limited, and may be four. Step S20 to step S23 may be counted as one cycle included in the N2 cycles.

In step S25, the controller 233 executes the second calibration process related to S2 based on the first measurement value and the second measurement value. Here, the controller 233 may execute the second calibration process in the period in which the variation in at least one of the output power or the input power of the distributed power supply is equal to or less than the predetermined threshold value. In other words, the processes in step S20 to step S24 may be executed in the period in which the variation in at least one of the output power or the input power of the distributed power supply is equal to or less than the predetermined threshold value.

Here, the controller 233 can acquire samples of N2 cycles. The second calibration process may be executed based on an average value of errors in the second measurement values, may be executed based on a minimum value of errors in the second measurement values, or may be executed based on a maximum value of errors in the second measurement values.

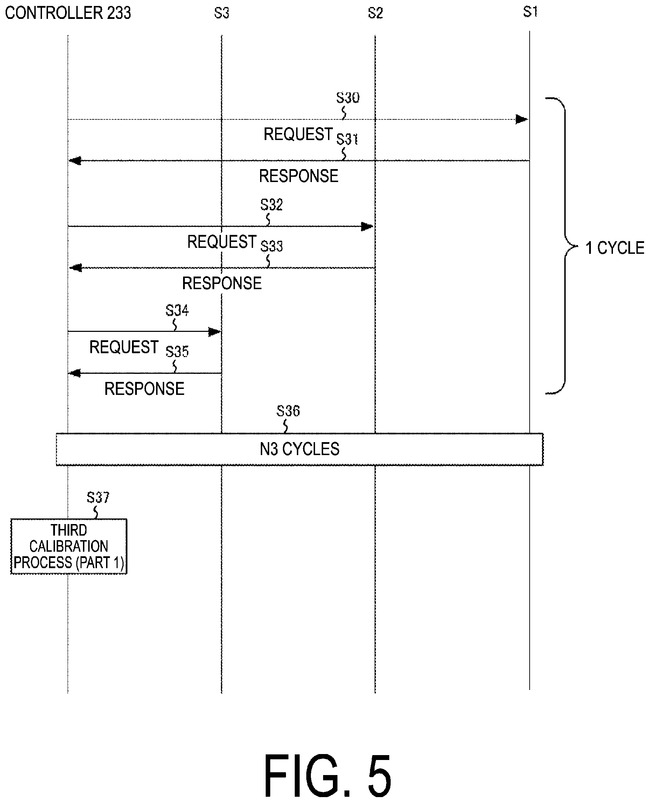

Third, the third calibration process (part 1) will be described with reference to FIG. 5. For example, the third calibration process (part 1) is a calibration process related to S3. The third calibration process (part 1) is executed at least after the first calibration process is executed. The third calibration process (part 1) may be executed after the second calibration process is executed.

As illustrated in FIG. 5, in step S30, the controller 233 requests the first measurement value from S1. In step S31, the controller 233 receives from S1 a response (first measurement value) to the request. In FIG. 5, S1 transmits the first measurement value in response to the request from the controller 233, but may autonomously transmit the first measurement value at an interval shorter than the predetermined time interval. Although not particularly limited, a message such as GET, GET response, and INF can be used as a message used in step S30 and step S31.

In step S32, the controller 233 requests the second measurement value from S2. In step S33, the controller 233 receives from S2 a response (second measurement value) to the request. In FIG. 5, S2 transmits the second measurement value in response to the request from the controller 233, but may autonomously transmit the second measurement value at an interval shorter than the predetermined time interval. Although not particularly limited, a message such as GET, GET response, and INF can be used as a message used in step S32 and step S33.

In step S34, the controller 233 requests the third measurement value from S3. In step S35, the controller 233 receives from S3 a response (third measurement value) to the request. In FIG. 5, S3 transmits the third measurement value in response to the request from the controller 233, but may autonomously transmit the third measurement value at an interval shorter than the predetermined time interval. Although not particularly limited, a message such as GET, GET response, and INF can be used as a message used in step S34 and step S35.

In step S36, the controller 233 sets step S30 to step S35 as one cycle, and executes such a process for N3 cycles. The N3 cycles is a repetition number for ensuring accuracy of the third calibration process (part 1), is not particularly limited, and may be four. Step S30 to step S35 may be counted as one cycle included in the N3 cycles.

In step S37, the controller 233 executes the third calibration process (part 1) related to S3 based on the first measurement value, the second measurement value, and the third measurement value (measurement value of S3). Here, the controller 233 may execute the third calibration process (part 1) in the period in which the variation in the power consumption of the load device 240 is equal to or less than a predetermined threshold value. The controller 233 may execute the third calibration process (part 1) in the period in which the variation in the output power of the PV panel 220 is equal to or less than the predetermined threshold value. In other words, the processes in step S30 to step S36 may be executed in the period in which the variation in the output power of the PV panel 220 is equal to or less than the predetermined threshold value.

Here, the controller 233 can acquire samples of the N3 cycles. The third calibration process (part 1) may be executed based on the average value of the error in the third measurement value of S3, or may be executed based on the minimum value of the error in the third measurement value of S3, and may be executed based on the maximum value of the error in the third measurement value of S3.

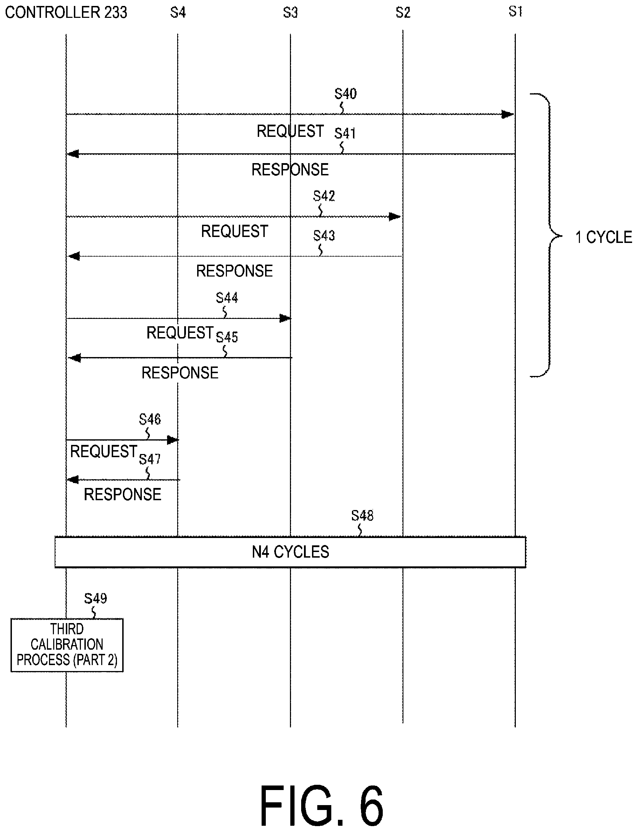

Fourth, the third calibration process (part 2) will be described with reference to FIG. 6. For example, the third calibration process (part 2) is a calibration process related to S4. The third calibration process (part 2) is executed at least after the first calibration process is executed. The third calibration process (part 2) may be executed after the second calibration process is executed. The third calibration process (part 2) may be executed after the third calibration process (part 1) is executed.

As illustrated in FIG. 6, in step S40, the controller 233 requests the first measurement value from S1. In step S41, the controller 233 receives from S1 a response (first measurement value) to the request. In FIG. 6, S1 transmits the first measurement value in response to the request from the controller 233, but may autonomously transmit the first measurement value at an interval shorter than the predetermined time interval. Although not particularly limited, a message such as GET, GET response, and INF can be used as a message used in step S40 and step S41.

In step S42, the controller 233 requests the second measurement value from S2. In step S43, the controller 233 receives from S2 a response (second measurement value) to the request. In FIG. 6, S2 transmits the second measurement value in response to the request from the controller 233, but may autonomously transmit the second measurement value at an interval shorter than the predetermined time interval. Although not particularly limited, a message such as GET, GET response, and INF can be used as a message used in step S42 and step S43.

In step S44, the controller 233 requests the third measurement value from S3. In step S45, the controller 233 receives from S3 a response (third measurement value) to the request. In FIG. 6, S3 transmits the third measurement value in response to the request from the controller 233, but may autonomously transmit the third measurement value at an interval shorter than the predetermined time interval. Although not particularly limited, a message such as GET, GET response, and INF can be used as a message used in step S44 and step S45.

In step S46, the controller 233 requests the third measurement value from S4. In step S47, the controller 233 receives from S4 a response (third measurement value) to the request. In FIG. 6, S4 transmits the third measurement value in response to the request from the controller 233, but may autonomously transmit the third measurement value at an interval shorter than the predetermined time interval. Although not particularly limited, a message such as GET, GET response, and INF can be used as a message used in step S46 and step S47.

In step S48, the controller 233 sets step S40 to step S47 as one cycle, and executes such a process for N4 cycles. The N4 cycles refer to a repetition number for ensuring accuracy of the third calibration process (part 2), are not particularly limited, and may be four. Step S40 to step S47 may be counted as one cycle included in the N4 cycles.

In step S49, the controller 233 executes the third calibration process (part 2) related to S4 based on the first measurement value, the second measurement value, and the third measurement value (measurement values of S3 and S4). Here, the controller 233 may execute the third calibration process (part 2) in the period in which the variation in the power consumption of the load device 240 is equal to or less than a predetermined threshold value. The controller 233 may execute the third calibration process (part 2) in the period in which the variation in the output power of the power storage unit 210 is equal to or less than the predetermined threshold value. In other words, the processes in step S40 to step S48 may be executed in the period in which the variation in the output power of the power storage unit 210 is equal to or less than the predetermined threshold value.

Here, the controller 233 can acquire samples of the N4 cycles. The third calibration process (part 2) may be executed based on the average value of the error in the third measurement value of S4, or may be executed based on the minimum value of the error in the third measurement value of S4, and may be executed based on the maximum value of the error in the third measurement value of S4.

### Actions and Effects

In the embodiment, the PCS 230 executes the first calibration process based on the reference measurement value and the first measurement value and subsequently executes the second calibration process related to S2 based on the first measurement value and the second measurement value. According to such a configuration, the processing time of the second calibration process can be shortened by replacing the reference measurement value received at the predetermined time interval with the first measurement value that can be received at an interval shorter than the predetermined time interval. When assuming a case where the second calibration process is executed in a state in which each of the breakers (B3 and B4 in FIG. 2) of a respective one of the distributed power supplies is disconnected, the time for disconnecting the distributed power supplies from the power system 110 can be shortened. The greater the number of the power meters for which the calibration process is to be executed, the greater the effect of such a reduction in processing time.

In the embodiment, the PCS 230 may execute the second calibration process in the period in which the variation in at least one of the output power or the input power of the distributed power supply is equal to or less than a predetermined threshold value. According to such a configuration, even when there are measurement errors in S3 and S4, the influence of the measurement errors in S3 and S4 can be reduced.

In the embodiment, the PCS 230 may execute the first calibration process and the second calibration process and subsequently execute the third calibration process based on the first measurement value, the second measurement value, and the third measurement value. According to such a configuration, the accuracy of the third calibration process can be ensured in a state where the measurement error in the second measurement value is within the acceptable range, and thus the period in which the variation in the power consumption of the load device 240 is equal to or less than the predetermined threshold value need not be ensured, and a decrease in the convenience for the user can be suppressed.

In the embodiment, the PCS 230 may execute the third calibration process in the period in which the variation in the power consumption of the load device 240 is equal to or less than the predetermined threshold value. According to such a configuration, even when there is a measurement error in S2, the influence of the measurement error in S2 can be reduced.

In the embodiment, the PCS 230 may execute the third calibration process (part 1) related to S3 in the period in which the variation in the output power of the PV panel 220 is equal to or less than the predetermined threshold value. According to such a configuration, even when there is a measurement error in S4, the influence of the measurement error in S4 can be reduced. In the same or a similar fashion, the PCS 230 may execute the third calibration process (part 2) related to S4 in the period in which the variation in the output power of the power storage unit 210 is equal to or less than the predetermined threshold value. According to such a configuration, even when there is a measurement error in S3, the influence of the measurement error in S3 can be reduced.

### Variation 1

A variation 1 of the embodiment will be described below. In the following, differences from the embodiment will be mainly described.

In the variation 1, the measurement value of the power meter provided in the facility 10 is transmitted to the outside of the facility 10 (for example, to the server 30). The measurement value of the power meter may be transmitted after a configuration process of the power meter is executed.

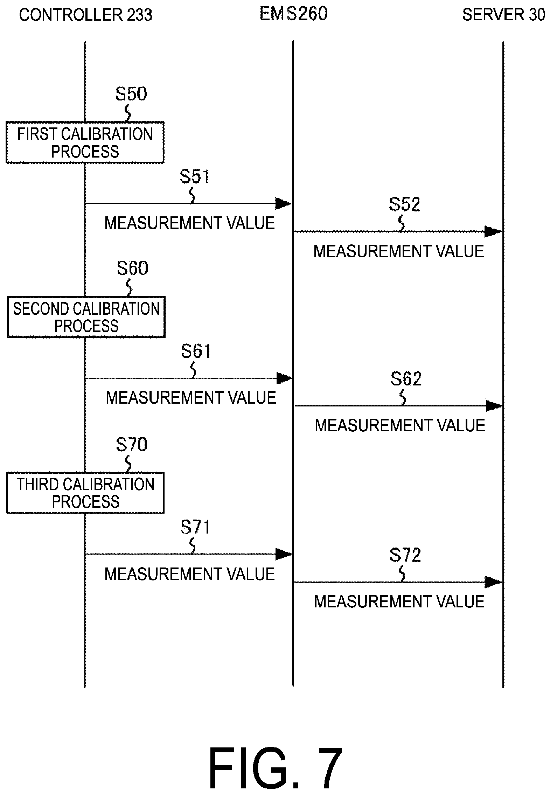

For example, as illustrated in FIG. 7, in step S50, the controller 233 executes the first calibration process. In step S51, the controller 233 starts a process of transmitting the first measurement value to the EMS 260. In step S52, the EMS 260 starts a process of transmitting the first measurement value to the server 30. The processes in step S51 and step S52 may be repeated until the first calibration process needs to be re-executed.

As illustrated in FIG. 7, in step S60, the controller 233 executes the second calibration process. In step S61, the controller 233 starts a process of transmitting the second measurement value to the EMS 260. In step S62, the EMS 260 starts a process of transmitting the second measurement value to the server 30. The processes in step S61 and step S62 may be repeated until the second calibration process needs to be re-executed.

As illustrated in FIG. 7, in step S70, the controller 233 executes the third calibration process. In step S71, the controller 233 starts a process of transmitting the third measurement value to the EMS 260. In step S72, the EMS 260 starts a process of transmitting the third measurement value to the server 30. The processes in step S71 and step S72 may be repeated until the third calibration process needs to be re-executed.

Here, the third calibration process may include a calibration process related to the first distributed power supply power meter (S3) and a calibration process related to the second distributed power supply power meter (S4). The controller 233 may start transmission of the measurement value of S3 after the calibration process related to S3 is executed. The controller 233 may start transmission of the measurement value of S4 after the calibration process related to S4 is executed.

In FIG. 7, step S50 to step 52, step S60 to step 62, and step S70 to step 72 may be processes independent of each other. The transmission of the measurement value of the power meter may be started after the calibration processes of all the power meters provided in the facility 10 are executed.

In the operation example described above, the first measurement value transmitted to the server 30 may be transmitted to the server 20. In the same or a similar fashion, the second measurement value and the third measurement value transmitted to the server 30 may be transmitted to the server 20.

In a case where the first measurement value, the second measurement value, and the third measurement value are transmitted to the server 20, the entity managing the server 20 may perform a billing process for the power or may perform a buying process for the power, based on at least one of the first measurement value, the second measurement value, or the third measurement value. In other words, the billing process or the buying process may be performed using the power meters (at least one selected from the group consisting of S1, S2, S3, and S4) that do not require authentication by a third party organization, without using the reference power meter 250 authenticated by a third party organization.

In a case where the first measurement value, the second measurement value, and the third measurement value are transmitted to the server 30, the entity managing the server 30 may perform maintenance of the distributed power supply (power storage unit 210 or PV panel 220) provided in the facility 10 based on at least one selected from the group consisting of the first measurement value, the second measurement value, and the third measurement value.

In a case where a measurement value of at least one selected from the group consisting of the first measurement value, the second measurement value, and the third measurement value (hereinafter, simply measurement value) is transmitted to the server 20 or the server 30, the PCS 230 or the EMS 260 may transmit the time at which the calibration process of the measurement value is executed (hereinafter, calibration time), and identification information of the power meter (for example, the reference power meter 250) used in the calibration process, along with the measurement value. According to such a calibration, even when the measurement value is measured without using the reference power meter 250 authenticated by the third party organization, the server 20 or the server 30 can confirm that the measurement value is a value having a certain reliability based on the calibration time and the identification information.

The billing process performed in the server 20 is a process of charging the power used by the facility 10 from the server 20 side to the facility 10 side or a user of the facility 10 (hereinafter, simply the facility 10 side).

The buying process may be a process in which in a case where ownership of the distributed power supply is owned not on the facility 10 side but on the third party side (for example, the server 20 side) even when the distributed power supply is under the control of the facility 10, a cost paid to the server 20 side in the billing process is regarded as a cost for the facility 10 side to buy the distributed power supply from a third party.

For example, by accumulating the cost generated by the billing process for 10 years, the accumulated cost may be used to pay for the purchase cost of the distributed power supply. In such a case, after the eleventh year, the ownership of the distributed power supply is transferred from the third party to the facility 10. After the transfer of the ownership, the transmission of some of information transmitted before the transfer is stopped, and the billing process need not be performed. For example, in a case where the distributed power supply is the PV panel 220, the process of transmitting the second measurement value to the server 20 may be stopped, and the billing process in the server 20 may also be stopped. Note that, after the transfer of the ownership, the transmission of some of the information transmitted before the transfer need not be stopped, and the billing process in the server 20 may be stopped.

### Variation 2

A variation 2 of the embodiment will be described below. In the following, differences from the embodiment will be mainly described.

In the embodiment, the case has been described in which each of separate DC/AC converters is provided for a respective one of two or more distributed power supplies. In contrast, in the variation 2, a case will be described in which a common DC/AC converter is provided for the two or more distributed power supplies. In other words, a case will be illustrated in which the PCS 230 is a hybrid PCS or a multi PCS.

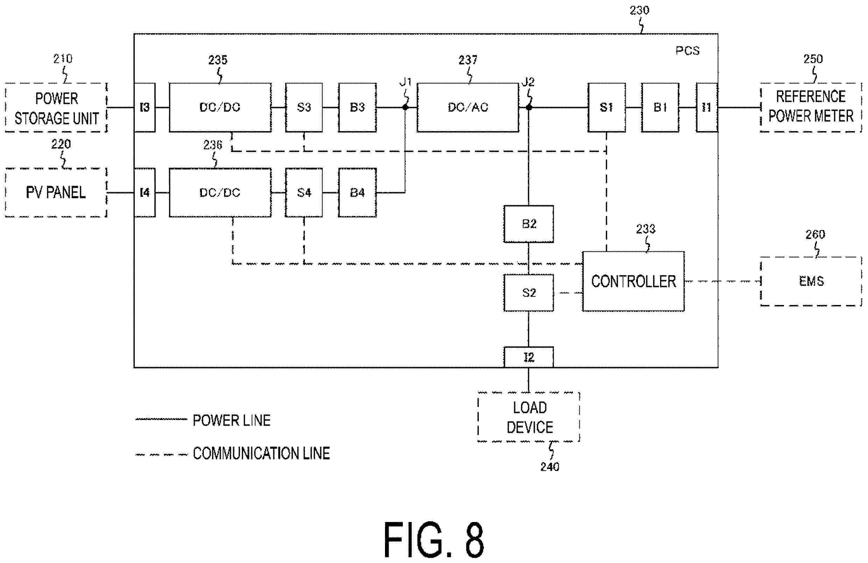

As illustrated in FIG. 8, the PCS 230 includes a DC/DC converter 235, a DC/DC converter 236, and a DC/AC converter 237 in place of the DC/AC converter 231 and the DC/AC converter 232 illustrated in FIG. 2.

The DC/DC converter 235 adjusts the voltage of DC power (discharging power) output from the power storage unit 210, and adjusts the voltage of DC power (charging power) to be input to the power storage unit 210. The DC/DC converter 236 adjusts DC power (generated power) output from the PV panel 220. The DC/AC converter 237 converts DC power output from the DC/DC converter 235 and the DC/DC converter 236 to AC power and converts AC power to DC power to be input to the DC/DC converter 235. Here, the DC/AC converter 237 is provided between J1 and J2.

### Other Embodiments

Although the present invention is described by the above-described embodiments, it should not be understood that the description and the drawings, which form a part of this disclosure, limit this invention. Various alternative embodiments, examples, and operational techniques will be apparent from this disclosure to those skilled in the art.

In the embodiment, the calibration processes (the first calibration process, the second calibration process, and the third calibration process) are executed by the controller 233 of the PCS 230. However, the embodiment is not limited to this example. The calibration processes may be executed by the EMS 260.

In the embodiment, the power storage unit 210 and the PV panel 220 are provided in the facility 10 as the distributed power supplies. However, the embodiment is not limited to this example. The distributed power supplies provided in the facility 10 may include a fuel cell apparatus, a wind power generation apparatus, and a geothermal power generation apparatus. The number of the distributed power supplies provided in the facility 10 may be one, or may be three or more.

In the embodiment, the third calibration process is executed after the first calibration process and the second calibration process are executed. However, the embodiment is not limited to this example. The third calibration process may be executed after the first calibration process is executed, and may be executed before the second calibration process is executed.

Although not particularly mentioned in the embodiment, the calibration processes (the first calibration process, the second calibration process, and the third calibration process) may be executed at a predetermined cycle (for example, one week, one month, or one year).

Although not particularly mentioned in the embodiment, theoretically, the first measurement value matches the sum of the second measurement value and the third measurement value. In other words, theoretically, the measurement value of S1 matches the sum of the measurement value of S2, the measurement value of S3, and the measurement values of S4. In such a case, assuming that the flow power is represented by a positive value, the reverse flow power is represented by a negative value, the power consumption of the load device 240 is represented by a positive value, the output power (discharging power) of the power storage unit 210 is represented by a negative value, the input power (charging power) of the power storage unit 210 is represented by a positive value, and the output power (generated power) of the PV panel 220 is represented by a negative value. Under such a premise, the second calibration process and the third calibration process may be executed so that the above-described relationship is established based on the measurement value of S1 after the first calibration process is executed. For example, in the second calibration process, the measurement values of S3 and S4 may be utilized in addition to the measurement values of S1 and S2. In such a case, the measurement values of S3 and S4 may be measurement values after the third calibration process is executed. In the third calibration process (part 1), the measurement value of S4 may be utilized in addition to the measurement values of S1, S2, and S3. In such a case, the measurement value of S4 may be a measurement value after the third calibration process (part 2) is executed. In the third calibration process (part 2), the measurement value of S3 may be utilized in addition to the measurement values of S1, S2, and S4. In such a case, the measurement value of S3 may be a measurement value after the third calibration process (part 1) is executed.

Although not particularly mentioned in the embodiment, the power consumption of the controller 233 and the EMS260 may be treated as a part of the power consumption of the load device 240.

Although not particularly mentioned in the embodiment, at least some functions of the EMS 260 may be executed by a cloud server connected to the network 120. The EMS 260 may be considered to include the cloud server.

Although not specifically mentioned in the embodiment, the power may be instantaneous power (kW) or may be an accumulated power amount (kWh) over a certain period (for example, 30 minutes).

## Claims

1. A power management system comprising:
a first receiver configured to receive, at a predetermined time interval, a reference measurement value of a reference power meter configured to measure flow power and/or reverse flow power of a facility comprising a distributed power supply and a load device;
a second receiver configured to receive, at an interval shorter than the predetermined time interval, a first measurement value of a first power meter provided closer to a power system side than a merging point of a power line connected to the distributed power supply and a power line connected to the load device;
a third receiver configured to receive, at an interval shorter than the predetermined time interval, a second measurement value of a second power meter configured to measure power consumption of the load device; and
a controller configured to execute a first calibration process related to the first power meter, based on a comparison result between the reference measurement value and the first measurement value and subsequently execute a second calibration process related to the second power meter, based on the first measurement value and the second measurement value.

2. The power management system according to claim 1, wherein
the controller is configured to execute the second calibration process in a period in which a variation in output power and/or input power of the distributed power supply is equal to or less than a predetermined threshold value.

3. The power management system according to claim 1 or 2, further comprising a fourth receiver configured to receive a third measurement value of a third power meter configured to measure output power and/or input power of the distributed power supply at an interval shorter than the predetermined time interval, wherein
the controller is configured to execute, after the second calibration process is executed, a third calibration process related to the third power meter, based on the first measurement value, the second measurement value, and the third measurement value.

4. The power management system according to claim 3, wherein
the controller executes the third calibration process in a period in which a variation in power consumption of the load device is equal to or less than a predetermined threshold value.

5. The power management system according to claim 3 or 4, wherein
the distributed power supply comprises a first distributed power supply and a second distributed power supply,
the third power meter comprises a first distributed power supply power meter configured to measure output power and/or input power of the first distributed power supply and a second distributed power supply power meter configured to measure output power and/or input power of the second distributed power supply, and
the controller is configured to execute, as the third calibration process, a calibration process related to the first distributed power supply power meter and/or a calibration process related to the second distributed power supply power meter.

6. The power management system according to claim 5, wherein
the controller is configured to
execute a calibration process related to the first distributed power supply power meter in a period in which a variation in at least one the output power and the input power of the second distributed power supply is equal to or less than a predetermined threshold value, or
execute a calibration process related to the second distributed power supply power meter in a period in which a variation in the output power and/or input power of the first distributed power supply is equal to or less than a predetermined threshold value.

7. The power management system according to claim 5 or 6, further comprising:
a transmitter configured to execute a calibration process related to the second distributed power supply power meter and subsequently transmit a measurement value of the second distributed power supply power meter to the outside.

8. A power conversion device comprising:
a first power interface connected to a power system;
a second power interface connected to a load device;
a third power interface connected to a distributed power supply;
a merging point of a power line connected to the distributed power supply and a power line connected to the load device; and
a converter configured to at least convert direct current power output from the distributed power supply to alternating current power.

9. A power management method comprising:
receiving, at a predetermined time interval, a reference measurement value of a reference power meter configured to measure flow power and/or reverse flow power of a facility comprising a distributed power supply and a load device;
receiving, at an interval shorter than the predetermined time interval, a first measurement value of a first power meter provided closer to a power system side than a merging point of a power line connected to the distributed power supply and a power line connected to the load device;
receiving, at an interval shorter than the predetermined time interval, a second measurement value of a second power meter configured to measure power consumption of the load device; and
executing a first calibration process related to the first power meter, based on a comparison result between the reference measurement value and the first measurement value and subsequently executing a second calibration process related to the second power meter, based on the first measurement value and the second measurement value.
